# FASCICULE DE BREVET EUROPEEN

(11) **EP 1 339 893 B1**
(45) Date de publication et mention de la délivrance du brevet: **20.02.2008**
(21) Numéro de dépôt: 01998671.0
(22) Date de dépôt: 26.11.2001
(51) Int. Cl.: C23C 14/06, G02B 1/00

(54) **PROCEDE DE DEPOT DE COUCHE ANTI-REFLETS A FROID**
NIEDRIGTEMPERATURVERFAHREN ZUR HERSTELLUNG EINER ANTIREFLEXIONSBESCHICHTUNG
METHOD FOR COLD PROCESS DEPOSITION OF AN ANTIGLARE LAYER

(30) Priorité: 28.11.2000 FR 0015334
(43) Date de publication de la demande: 03.09.2003
(73) Titulaire: ESSILOR INTERNATIONAL COMPAGNIE GENERALE D'OPTIQUE, 94227 Charenton cédex (FR)
(72) Inventeur: HELMSTETTER, Yvon, 55500 Boviolles (FR); BERNHARD, Jean-Daniel, Le Clos Torrel, Longeville en Barrois, 55500 Bar-Le-Duc (FR); ARROUY, Frédéric, 55500 Velaines (FR)
(74) Mandataire: Hirsch & Associés
(86) Numéro de dépôt international: PCT/FR2001/003723
(87) Numéro de publication internationale: WO 2002/044440

(56) Documents cités:
- US-A- 3 330 681
- PATENT ABSTRACTS OF JAPAN vol. 009, no. 141 (P-364), 15 juin 1985 (1985-06-15) & JP 60 022101 A (MATSUSHITA DENKI SANGYO KK), 4 février 1985 (1985-02-04)
- PATENT ABSTRACTS OF JAPAN vol. 1996, no. 06, 28 juin 1996 (1996-06-28) & JP 08 041230 A (OIKE IND CO LTD), 13 février 1996 (1996-02-13)
- PATENT ABSTRACTS OF JAPAN vol. 013, no. 030 (P-816), 24 janvier 1989 (1989-01-24) & JP 63 228101 A (NIPPON SHEET GLASS CO LTD), 22 septembre 1988 (1988-09-22)
- PATENT ABSTRACTS OF JAPAN vol. 1995, no. 04, 31 mai 1995 (1995-05-31) & JP 07 027902 A (DAINIPPON PRINTING CO LTD), 31 janvier 1995 (1995-01-31)
- PATENT ABSTRACTS OF JAPAN vol. 1998, no. 10, 31 août 1998 (1998-08-31) & JP 10 123303 A (VICTOR CO OF JAPAN LTD), 15 mai 1998 (1998-05-15)

## Description

La présente invention a pour objet un procédé de réalisation de traitement anti-reflets sur un substrat en matériau organique, en particulier une lentille ophtalmique, en utilisant la technique du dépôt par évaporation sous vide. De tels dépôts sont généralement réalisés au moyen d'oxydes métalliques de haut et bas indice de réfraction.

L'efficacité d'un traitement anti-reflets dépend en grande partie de la valeur des indices de réfraction des couches déposées. Les contraintes liées au type de dépôt utilisé ainsi qu'à la nature des substrats à traiter limitent les matériaux utilisables pour ces traitements.

Les fabricants sont amenés à concevoir des traitements anti-reflets de plus en plus performants. Pour information, dans le domaine ophtalmique, l'efficacité d'un tel traitement, en termes de réflexion par face, se situe entre 1,6 et 2,5% pour un traitement de faible efficacité, elle est comprise entre 1,0 et 1,8% pour un traitement d'efficacité moyenne et doit aujourd'hui être comprise entre 0,3 et 0,8% pour un traitement de haute efficacité.

Ces contraintes imposent la recherche de nouveaux matériaux, parfois difficiles à mettre en oeuvre d'un point de vue industriel. Une autre voie peut consister à utiliser des matériaux auparavant réservés aux substrats en matière minérale.

Afin de réaliser un traitement anti-reflets de haute efficacité, il est nécessaire que la dernière couche déposée soit d'un indice le plus faible possible. Pour les substrats organiques, SiO₂ est souvent utilisé en raison de son indice de réfraction 1,48, de ses bonnes propriétés d'adhésion, de résistance à la rayure et à la corrosion et de sa facilité de dépôt.

MgF₂ est très largement utilisé pour les substrats en matière minérale en raison de son très bas indice de réfraction, 1,38. L'inconvénient de ce matériau réside dans sa friabilité et son manque d'adhésion lorsqu'il est déposé à des températures en dessous de 200°C.

MgF₂ n'est généralement pas utilisé pour les substrats organiques car ceux-ci ne peuvent être chauffés au-delà de 150°C sous peine de jaunissement et de détérioration.

Il convient donc de trouver un procédé permettant de déposer du MgF₂ sur un substrat organique (dépôt dit à froid) et de trouver d'autres matériaux qui pourraient convenir.

On connaît de JP 8-236635 le dépôt d'une couche de MgF₂ sur un substrat organique au moyen de la technologie de pulvérisation cathodique. Les couches déposées par pulvérisation cathodique montrent cependant des caractéristiques physico-chimiques particulières. Les couches déposées sont en particulier généralement plus denses, ce qui peut poser un problème d'adhérence. Le document enseigne qu'un tel dépôt réalisé au moyen d'évaporation sous vide conduit à des couches présentant un faible taux de cristallisation, ce qui entraîne une résistance à l'abrasion insuffisante.

Un empilement anti-reflets sur matériau organique dans le domaine de l'ophtalmique dont la dernière couche est en MgF₂ est également décrit dans le document EP-A-619504. Le document indique que les couches décrites sont réalisées par des procédés assistés par plasma et dans certaines limites non spécifiées par pulvérisation cathodique. Le procédé de dépôt le plus couramment utilisé et le plus économique est cependant l'évaporation sous vide sans assistance plasma. Les couches obtenues par évaporation avec assistance plasma présentent en outre une densité plus élevée que celles obtenues sans assistance. Or une densité élevée entraîne des fortes contraintes dans ces couches, ce qui peut conduire à une adhésion de qualité inférieure.

Le document JP 61250601 décrit également un empilement anti-reflets sur un substrat organique. Selon ce document, on utilise du SiO₂ comme couche extérieure de bas indice de réfraction, et de préférence un empilement de trois couches du type Y₂O₃/TiO₂/SiO₂. Lors du dépôt de l'empilement, l'interface d'au moins l'une des couches est traitée par bombardement ionique. Ce traitement permet d'améliorer l'adhérence des couches. L'utilisation du MgF₂ comme matériau à bas indice de réfraction n'est ni décrit ni suggéré dans ce document.

Le document JP 7076048 décrit un empilement anti-reflets déposé sur substrat organique. Il est précisé que la couche extérieure, en MgF₂, est déposée à basse température sous assistance ionique (technique IAD, Ion Assisted Deposition) et que la surface sur laquelle est déposée cette couche subit au préalable un traitement de nettoyage par bombardement ionique et/ou par plasma. Cependant, il s'avère que l'utilisation de la technique IAD présente un certain nombre d'inconvénients. Ce type d'assistance est utilisé généralement pour densifier les couches déposées. Mais en contrepartie, les couches plus denses ont une adhérence moindre. En outre, l'assistance ionique peut rendre la couche de MgF₂ plus absorbante, ce qui est un inconvénient très gênant pour les applications ophtalmiques. Enfin, ce type d'assistance alourdit le procédé et entraîne des surcoûts de production notables.

L'invention consiste alors à proposer un procédé de fabrication d'un empilement anti-reflets par évaporation sous vide sur un substrat organique à une température inférieure à 150°C, comportant les étapes de dépôt d'au moins une couche de matériau d'indice de réfraction différent du MgF₂, de préparation de la surface du substrat ainsi revêtu, et de dépôt d'une couche extérieure de MgF₂ sans assistance ionique. De préférence, l'évaporation sous vide est réalisée à une température inférieure à 100°C.

La préparation de surface est de préférence choisie parmi les traitements suivants : bombardement ionique, bombardement électronique, attaque chimique ex situ.

Selon un mode de réalisation préféré, ladite couche est constituée par un matériau à haut indice de réfraction choisi dans le groupe des oxydes simples ou mixtes, ou de mélanges d'oxydes, de métaux du groupe IIIb, IVb, Vb, Vib, VIIb et des lanthanides. De préférence, les métaux sont choisis dans le groupe de Pr, La, Ti, Zr, Ta et Hf. Encore préférés sont les matériaux à haut indice de réfraction choisis dans le groupe suivant : ZrO₂, PrTiO₃, mélanges de Pr₂O₃ et de TiO₂, mélanges de Pr₆O₁₁ et de TiO₂, mélanges de La₂O₃ et de TiO₂ et mélanges de ZrO₂ et de TiO₂.

Selon un mode de réalisation, ladite couche de matériau d'indice de réfraction différent du MgF₂ est un revêtement dur. Selon un autre mode de réalisation, ladite couche de matériau d'indice de réfraction différent du MgF₂ est une couche anti-chocs. Selon encore un autre mode de réalisation, ladite couche de matériau d'indice de réfraction différent du MgF₂ est une couche anti-franges.

De préférence, le procédé comporte avant le dépôt de la couche de matériau à indice de réfraction différent du MgF₂ l'étape préalable du dépôt d'une couche de bas indice de réfraction. De préférence, la couche de bas indice de réfraction a une épaisseur de 40 et 200 nm, de préférence 60 nm.

Selon un mode de réalisation, l'étape de dépôt du matériau à indice de réfraction différent du MgF₂ comprend les étapes de dépôt d'une première couche de matériau à indice de réfraction différent du MgF₂, le dépôt d'une couche de matériau à bas indice de réfraction, et le dépôt d'une deuxième couche de matériau à indice de réfraction différent du MgF₂.

De préférence, la couche à bas indice de réfraction est en SiO₂. Il est préféré que la première couche de matériau à indice de réfraction différent du MgF₂ ait une épaisseur de 10 à 40 nm. Il est également préféré que la couche de bas indice de réfraction ait une épaisseur de 10 à 100 nm, de préférence 40 nm.

Avantageusement, la deuxième couche de matériau à indice de réfraction différent du MgF₂ a une épaisseur de 50 à 150 nm, de préférence de 120 à 130 run.

Le substrat organique est de préférence composé de polycarbonate.

De préférence, la couche extérieure de MgF₂ a une épaisseur de 50 à 100 nm, de préférence de 80 à 90 nm.

Selon un mode de réalisation du procédé selon l'invention comporte l'étape subséquente de dépôt d'une couche modifiant l'énergie de surface.

Elle concerne également un substrat organique revêtu d'un empilement anti-reflets, en particulier une lentille ophtalmique susceptible d'être obtenue par le procédé selon l'invention.

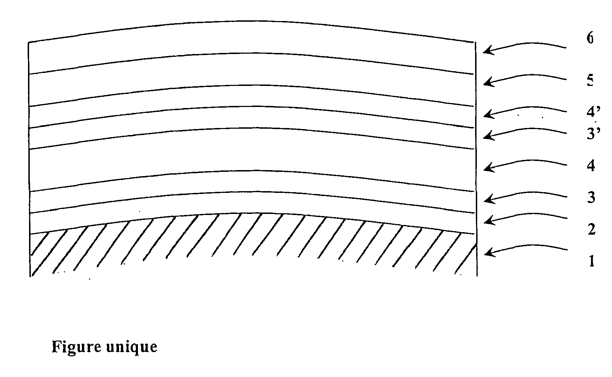

D'autres caractéristiques et avantages de l'invention apparaîtront à la lecture de la description qui suit de modes de réalisation de l'invention, donnés à titre d'exemple et en référence au dessin annexé, qui montre :
Figure unique : empilement anti-reflets obtenu selon un mode de réalisation de l'invention.

Les travaux et essais entrepris par la Demanderesse dans le domaine du dépôt de MgF₂ sur des substrats organiques par évaporation sous vide ont conduit à la constatation que contrairement à l'enseignement de la littérature, il était possible de réaliser de telles couches par évaporation sous vide sans recourir à l'assistance ionique.

Un avantage du procédé selon l'invention réside dans le fait qu'il permet le dépôt de ces couches dans des conditions plus économiques.

Un autre avantage du procédé selon l'invention est qu'il permet d'obtenir des substrats organiques comportant des couches ayant les mêmes caractéristiques physico-chimiques que celles déposées sur des substrats minéraux.

L'invention permet en outre l'obtention d'empilements anti-reflets sur des substrats organiques qui présentent les caractéristiques requises, notamment en termes d'adhérence, mais aussi en termes de résistance aux rayures.

Un exemple d'un empilement pouvant être obtenu par le procédé selon l'invention est illustré à la figure et décrit ci-dessous (les indices de réfraction sont donnés pour une longueur d'onde de 550 nm, les épaisseurs données sont des épaisseurs physiques).

Dans le cadre de l'invention, on entend par « substrats organiques » des substrats en matériaux polymères, en contraste avec les substrats en verre minéral. Sont particulièrement visés les substrats en polycarbonate, polyméthylméthylacrylate, polythiouréthanne et poly(bisphénol-A-bisallylcarbonate, et en particulier le poly-(diéthylèneglycolbisallylcarbonate), disponible dans le commerce sous la dénomination de CR39.

Selon le mode de réalisation illustré à la figure, un substrat organique (1) est muni d'un revêtement dur (2) aussi désigné comme « hard coat ». Ce revêtement dur a typiquement une épaisseur entre 300 et 10000 nm. Généralement, il est composé de silice ou d'un vernis, par exemple un vernis d'époxyde ou de polysiloxane. Il est également possible d'appliquer une couche de polymérisation par plasma, de préférence également composée d'un polysiloxane, et/ou d'un film DLC (acronyme anglais pour « diamond like coating », revêtement de type diamant). Ce revêtement dur n'est cependant pas obligatoire.

L'empilement anti-reflets déposé selon l'invention comporte une couche en matériau ayant un indice différent de celui du MgF₂ (4). Ce matériau peut être par exemple un vernis ou du SiO₂.

Selon un mode de réalisation préféré, cette couche est en matériau à haut indice de réfraction. Dans le cadre de l'invention, on désigne comme « matériau à haut indice de réfraction » les matériaux ayant un indice de réfraction supérieur à 1,6 et de préférence de 2 à 2,6. En pratique, sont mis en oeuvre le plus souvent pour les empilements anti-reflets des matériaux à haut indice de réfraction ayant un indice de réfraction de 1,9 à 2,3.

De tels matériaux à haut indice de réfraction convenant à la mise en oeuvre du procédé selon l'invention sont par exemple les oxydes simples ou mixtes ou des mélanges d'oxydes de métaux du groupe IIIb, IVb, Vb, VIb, VIIb et des lanthanides. De préférence, on met en oeuvre les oxydes simples ou mixtes ou des mélanges d'oxydes des métaux Pr, La, Ti, Zr, Ta, Hf, dont ZrO₂, PrTiO₃, mélanges de Pr₂O₃ et de TiO₂, mélanges de Pr₆O₁₁ et de TiO₂, mélanges de La₂O₃ et de TiO₂ et mélanges de ZrO₂ et TiO₂ sont particulièrement préférés.

La couche en matériau à haut indice de réfraction peut cependant être elle-même constituée d'un empilement comportant d'autres couches. Ainsi, dans l'empilement selon le mode de réalisation illustré à la figure, la couche en matériau à haut indice de réfraction (4) est divisée en deux couches (4) et (4') séparées par une couche en matériau à bas indice de réfraction (3'). Avantageusement, les couches en matériau à haut indice de réfraction (4) et (4') peuvent être constituées du même-matériau.

La couche en matériau à haut indice de réfraction (4) peut également être divisée en un plus grand nombre de couches séparées par des couches de matériaux à indice de réfraction plus faible.

Les couches à bas indice de réfraction (3) et (3') présentes dans l'empilement obtenu selon le mode de réalisation illustré peuvent être en un matériau dont l'indice de réfraction est inférieur à celui du substrat, en particulier inférieur à 1,5. De tels matériaux sont par exemple le SiO₂ ou les fluorures de métaux, le SiO₂ étant préféré. Avantageusement, les couches (3) et (3') sont constituées du même matériau.

L'empilement anti-reflets obtenu selon l'invention comporte une couche extérieure de bas indice de réfraction (5) formée de MgF₂. L'enseignement de la littérature indique que ce matériau est difficile à déposer avec des caractéristiques satisfaisantes par des techniques compatibles avec des matériaux organiques, c'est-à-dire à basse température. Pourtant, il a été trouvé qu'un dépôt sans assistance ionique sur une couche inférieure ayant subi une préparation conduit à des substrats de qualité remarquable.

Cette étape de préparation selon l'invention peut être par exemple un traitement par bombardement ionique, bombardement électronique ou encore par attaque chimique ex situ.

Dans l'empilement obtenu selon un mode de réalisation de l'invention, le MgF₂ est déposé en une épaisseur de 50 à 100 nm, de préférence de 80 à 90 nm.

Il est possible de déposer par-dessus la couche extérieure en MgF₂ une ou plusieurs couches permettant de modifier l'énergie de surface afin de faciliter le nettoyage et/ou une couche permettant de diminuer l'effet électrostatique, comme par exemple une couche conductrice.

Il s'est avéré que le procédé selon l'invention, notamment grâce à l'étape de préparation du substrat éventuellement déjà revêtu d'autres couches avant le dépôt de MgF₂ permet l'obtention d'empilements anti-reflets ayant des caractéristiques très satisfaisantes sur le plan de l'adhérence, de la résistance aux rayures, de la résistance aux attaques chimiques et de la facilité de nettoyage.

### EXEMPLES

Afin de caractériser les empilements anti-reflets obtenus selon le procédé de l'invention, on a fabriqué des empilements anti-reflets sur substrats organiques (CR39) avec différents matériaux à haut indice de réfraction.

Les substrats ont été revêtus d'un empilement de quatre couches de type SiO₂/ HI/ SiO₂/ HI/ MgF₂ / Top coat (HI signifie matériau à haut indice de réfraction).

Le procédé selon l'invention a été réalisé dans un évaporateur sous vide de type Balzers BAK 760.

Les différents matériaux HI utilisés sont portés dans le tableau ci-dessous. Les fournisseurs respectifs sont indiqués entre parenthèses. Pour chacun des matériaux à haut indice de réfraction, on a réalisé un substrat en soumettant la dernière couche de matériau HI à un bombardement ionique sous une tension de 100 V, un courant de 1 A pendant 1 minute et en présence d'argon comme gaz, tandis qu'un deuxième substrat n'est pas traité par bombardement ionique. Ensuite, on procède au dépôt de MgF₂ par évaporation sous vide, sans assistance ionique.

Dans les exemples donnés, les substrats sont revêtus avec un vernis à base d'hydrolysats de silane tel que décrit dans le brevet français FR 2 702 486 de la Demanderesse et plus particulièrement tel que décrit dans l'exemple 3.

La couche extérieure, qui permet de faciliter le nettoyage est un matériau de type fluoroorganosilane hydrophobe. A titre d'exemple, est utilisé pour la réalisation de cette couche un matériau commercialisé par la société Optron sous la dénomination de OF 110.

Les substrats ainsi obtenus sont ensuite soumis à une série de tests afin d'évaluer leurs performances.

Les substrats sont soumis au test appelé test N x 10 coups et décrit dans la demande WO99/49097. Ce test sollicite l'adhésion des couches minces déposées sur un substrat organique. Les résultats sont consignés dans le tableau 1, où sont distinguées les faces concaves (CC) par rapport aux faces convexes (CX) des substrats. On voit que les substrats fabriqués selon le procédé de l'invention donnent des résultats au moins comparables, et meilleurs pour la plupart des matériaux à haut indice de réfraction.

Les substrats ont également été soumis au test appelé test « paille de fer ». Ce test est réalisé à l'aide d'une laine d'acier extra fine n° 000 de STARWAX. Un morceau de laine d'acier d'environ 3 cm est plié sur lui-même et appliqué sur le substrat revêtu avec une pression constante. Après réalisation de 5 allers retours, l'état du substrat est apprécié visuellement et une note est attribuée selon la gradation suivante :
1 substrat intact, aucune rayure ou présence de fines rayures localisées
3 substrat avec rayures plus intenses et arrachements légers (rayures blanches)
5 substrat avec rayures blanches couvrant presque la totalité de la surface testée (arrachement du vernis ou du substrat correspondant). Le résultat obtenu correspond à celui du test de la paille de fer appliqué au CR 39 non vernis.

**Tableau 1**

| Matériau HI | Nx10 coups selon l'invention | | Nx10 coups comparaison | | Paille de fer Selon l'invention | Paille de fer comparaison |
|---|---|---|---|---|---|---|
| | CC | CX | CX | CC | | |
| PrTiO_{3 (Bea Merck)} | >12 | >12 | >12 | >12 | 1.2 | 5 |
| Mélange de Pr₆O₁₁ et TiO_{2 (Cerac)} | >12 | >12 | | | 1.3 | |
| LaTiO_{3 (H4 Merck)} | >12 | >12 | >12 | >12 | 1.4 | 3 |
| Mélange de La₂O₃ et de TiO_{2 (Aldrich)} | >12 | >12 | >12 | >12 | 1 | |
| ZrO_{2 (Optron)} | >12 | >12 | >12 | >12 | 1.2 | 5 |
| Mélange de ZrO₂ et de TiO_{2 (OM4 Optron)} | >12 | >12 | >12 | 9 | 2 | 5 |
| TiO_{2 (Merck)} | >12 | >12 | 3 | 3 | 3 | 5 |
| Ta₂O_{5 (Merck - Optron)} | >12 | >12 | 9 | 9 | 3 | 5 |
| HfO_{2 (Merck-Optron)} | >12 | >12 | 3 | 3 | 3 | 5 |

Les substrats évalués jusqu'à 3 sont acceptés, ceux à 5 sont rejetés. Le test est réalisé pour 5 à 10 substrats chaque fois et la moyenne des résultats est portée dans le tableau 1.

On s'aperçoit que les résultats du test de la paille de fer sont très satisfaisants pour les substrats ayant subi le bombardement ionique, alors que l'ensemble des autres substrats donne de mauvais résultats. Les matériaux PrTiO₃, mélange de Pr₆O₁₁ et TiO₂, LaTiO₃, mélange de La₂O₃ et de TiO₂, ZrO₂ et mélange de ZrO₂ et de TiO₂ donnent des résultats particulièrement remarquables.

En conclusion, pour l'ensemble des matériaux testés figurant dans le tableau, les performances obtenues pour le test Nx10 coups et paille de fer sont bonnes et répondent au standard Essilor.

Il ressort de ces constatations, que nous avons identifié un procédé de dépôt à froid de MgF₂, sur un substrat organique qui ne nécessite pas d'utilisation de l'IAD. Ce procédé permet en outre de déposer des couches de MgF₂ de propriétés équivalentes à celles des couches déposées à chaud.

Le substrat organique revêtu d'un empilement anti-reflets selon l'invention peut être utilisé dans des domaines variés, notamment en optique. Il est tout particulièrement utile dans la fabrication de lentilles ophtalmiques.

## Revendications

1. Procédé de fabrication d'un empilement anti-reflets par évaporation sous vide sur un substrat organique (1) à une température inférieure à 150°C, comportant les étapes de :
- dépôt d'au moins une couche de matériau d'indice de réfraction différent du MgF₂ (4,4');
- préparation de la surface du substrat ainsi revêtu ; et
- dépôt d'une couche extérieure de MgF₂ (5) sans assistance ionique.

2. Procédé selon la revendication 1, dans lequel l'évaporation sous vide est réalisée à une température inférieure à 100°C.

3. Procédé selon la revendication 1 ou 2, dans lequel la préparation de surface est choisie parmi les traitements suivants : bombardement ionique, bombardement électronique, attaque chimique ex situ.

4. Procédé selon l'une des revendications 2 à 3, dans lequel ladite couche est en matériau à haut indice de réfaction choisi dans le groupe des oxydes simples ou mixtes ou mélanges de métaux du groupe IIIb, IVb, Vb, VIb, VIIb et des lanthanides.

5. Procécé selon l'une des revendications 2 à 4, dans lequel les métaux sont choisis dans le groupe de Pr, La, Ti, Zr, Ta et Hf.

6. Procédé selon l'une des revendications 2 à 5, dans lequel les matériaux à haut indice de réfraction sont choisis dans le groupe de ZrO₂, PrTiO₃, mélanges de Pr₂O₃ et de TiO₂, mélanges de Pr₆O₁₁ et de TiO₂, mélanges de La₂O₃ et de TiO₂ et mélanges de ZrO₂ et de TiO₂.

7. Procédé selon l'une des revendications 1 à 6, **caractérisé en ce que** ladite couche de matériau d'indice de réfraction différent du MgF₂ est un revêtement dur.

8. Procédé selon l'une des revendications 1 à 7, **caractérisé en ce que** ladite couche de matériau d'indice de réfraction différent du MgF₂ est une couche anti-chocs.

9. Procédé selon l'une des revendications 1 à 8, **caractérisé en ce que** ladite couche de matériau d'indice de réfraction différent du MgF₂ est une couche anti-franges.

10. Procédé selon l'une des revendications 1 à 9. comportant avant le dépôt de la couche de matériau à indice de réfraction différent du MgF₂ (4, 4') l'étape préalable du dépôt d'une couche de bas indice de réfraction (3).

11. Procédé selon la revendication 10, dans lequel la couche de bas indice de réfraction (3) a une épaisseur de 40 et 200 nm, de préférence 60 nm.

12. Procédé selon l'une des revendications 1 à 11, dans lequel l'étape de dépôt du matériau à indice de réfraction différent du MgF₂ comprend les étapes de :
- dépôt d'une première couche de matériau à indice de réfraction différent du MgF₂ (4) ;
- dépôt d'une couche de matériau à bas indice de réfraction (3') ; et
- dépôt d'une deuxième couche de matériau à indice de réfraction différent du MgF₂ (4').

13. Procédé selon la revendication 12, dans lequel la couche à bas indice de réfraction est en SiO₂.

14. Procédé selon la revendication 12 ou 13, dans lequel la première couche de matériau à indice de réfraction différent du MgF₂ (4) a une épaisseur de 10 à 40 nm.

15. Procédé selon l'une des revendications 12 à 14, dans lequel la couche de bas indice de réfraction (3') a une épaisseur de 10 à 100 nm, de préférence 40 nm.

16. Procédé selon l'une des revendications 12 à 15, dans lequel la deuxième couche de matériau à indice de réfraction différent du MgF₂ (4') a une épaisseur de 50 à 150 nm, de préférence de 120 à 130 nm.

17. Procédé selon l'une des revendications 1 à 16, dans lequel le substrat organique (1) est composé de polycarbonate.

18. Procédé selon l'une des revendications 1 à 17, dans lequel la couche extérieure de MgF₂ (5) a une épaisseur de 50 à 100 nm, de préférence de 80 à 90 nm.

19. Procédé selon l'une des revendications 1 à 18, comportant l'étape subséquente de dépôt d'une couche modifiant l'énergie de surface (6).

20. Substrat organique revêtu d'un empilement anti-reflets, en particulier lentille ophtalmique susceptible d'être obtenue par le procédé selon l'une des revendications 1 à 19.

## Claims

1. A process for manufacturing a multilayer antireflection coating by vacuum evaporation on an organic substrate (1) at a temperature below 150°C, comprising the following steps:
- deposition of at least one layer (4, 4') of material of refractive index different from MgF₂;
- preparation of the surface of the substrate thus coated; and
- deposition of an outer layer (5) of MgF₂ without ion assistance

2. The process as claimed in claim 1, in which the vacuum evaporation is carried out at a temperature below 100°C.

3. The process as claimed in claim 1 or 2, in which the surface preparation is chosen from among the following treatments: ion bombardment, electron bombardment and etching carried out *ex situ*.

4. The process as claimed in either of claims 2 and 3, in which said layer is made of a material having a high refractive index chosen from a group of simple or mixed oxides or mixtures of metals of groups IIIb, IVb, Vb, VIb, VIIb and lanthanides.

5. The process as claimed in one of claims 2 to 4, in which the metals are chosen from the group Pr, La, Ti, Zr, Ta and Hf.

6. The process as claimed in one of claims 2 to 5, in which the materials having a high refractive index are chosen from the group consisting of ZrO_{2,} PrTiO₃, Pr₂O₃/TiO₂ mixtures, Pr₆O₁₁/TiO₂ mixtures, La₂O₃/TiO₂ mixtures and ZrO₂/TiO₂ mixtures.

7. The process as claimed in one of claims 1 to 6, **characterized in that** said layer of material of refractive index different from MgF₂ is a hard coating.

8. The process as claimed in one of claims 1 to 7, **characterized in that** said layer of material of refractive index different from MgF₂ is an impact-resistant layer.

9. The process as claimed in one of claims 1 to 8, **characterized in that** said layer of material of refractive index different from MgF₂ is an antifringe layer.

10. The process as claimed in one of claims 1 to 9, comprising, before the layer (4, 4') of material of refractive index different from MgF₂ is deposited, the prior step of depositing a layer (3) of low refractive index.

11. The process as claimed in claim 10, in which the layer (3) of low refractive index has a thickness of between 40 and 200 nm, preferably 60 nm.

12. The process as claimed in one of claims 1 to 11, in which the step of depositing the material of refractive index different from MgF₂ comprises the following steps:
- deposition of a first layer (4) of material of refractive index different from MgF₂;
- deposition of a layer (3') of material having a low refractive index; and
- deposition of a second layer (4') of material of refractive index different from MgF₂.

13. The process as claimed in claim 12, in which the layer having a low refractive index is made of SiO₂.

14. The process as claimed in either of claims 12 and 13, in which the first layer (4) of material of refractive index different from MgF₂ has a thickness of 10 to 40 nm.

15. The process as claimed in one of claims 12 to 14, in which the layer (3') of material having a low refractive index has a thickness of 10 to 100 nm, preferably 40 nm.

16. The process as claimed in one of claims 12 to 15, in which the second layer (4') of material of refractive index different from MgF₂ has a thickness of 50 to 150 nm, preferably 120 to 130 nm.

17. The process as claimed in one of claims 1 to 16, in which the organic substrate (1) is composed of polycarbonate.

18. The process as claimed in one of claims 1 to 17, in which the outer layer (5) of MgF₂ has a thickness of 50 to 100 nm, preferably 80 to 90 nm.

19. The process as claimed in one of claims 1 to 18, comprising the subsequent step of depositing a layer (6) that modifies the surface energy.

20. An organic substrate coated with a multilayer antireflection coating, in particular an ophthalmic lens that can be obtained by the process as claimed in one of claims 1 to 19.

## Patentansprüche

1. Verfahren zur Herstellung einer Antireflexionsbeschichtung durch Vakuumverdampfung auf einem organischen Substrat (1) bei einer Temperatur unter 150 °C, umfassend die folgenden Schritte:
- Aufbringen mindestens einer Materialschicht mit einem zu MgF₂ unterschiedlichen Brechungsindex (4, 4');
- Vorbereitung der Oberfläche des so überzogenen Substrats; und
- Aufbringen einer Außenschicht aus MgF₂ (5) ohne ionische Unterstützung.

2. Verfahren nach Anspruch 1, bei dem die Vakuumverdampfung bei einer Temperatur unter 100 °C erfolgt.

3. Verfahren nach Anspruch 1 oder 2, bei dem die Vorbereitung der Oberfläche unter folgenden Behandlungen ausgewählt wird: Ionenbeschuss, Elektronenbeschuss, chemischer Angriff ex situ.

4. Verfahren nach einem der Ansprüche 2 bis 3, bei dem die Schicht aus einem Material mit hohem Brechungsindex ist, das in der Gruppe der einfachen oder gemischten Oxide oder den Metallgemischen der Gruppe IIIb, IVb, Vb, VIb, VIIb und Lanthaniden ausgewählt wird.

5. Verfahren nach einem der Ansprüche 2 bis 4, bei dem die Metalle in der Gruppe von Pr, La, Ti, Zr, Ta und Hf ausgewählt werden.

6. Verfahren nach einem der Ansprüche 2 bis 5, bei dem die Materialien mit hohem Brechungsindex in der Gruppe von ZrO₂, PrTiO₃, der Gemische von Pr₂O₃ und TiO₂, der Gemische von Pr₆O₁₁ und TiO₂, der Gemische von La₂O₃ und TiO₂ und der Gemische von ZrO₂ und TiO₂ ausgewählt werden.

7. Verfahren nach einem der Ansprüche 1 bis 6, **dadurch gekennzeichnet, dass** die Materialschicht mit hohem Brechungsindex, der sich von jenem des MgF₂ unterscheidet, ein harter Überzug ist.

8. Verfahren nach einem der Ansprüche 1 bis 7, **dadurch gekennzeichnet, dass** die Materialschicht mit hohem Brechungsindex, der sich von jenem des MgF₂ unterscheidet, eine stoßfeste Schicht ist.

9. Verfahren nach einem der Ansprüche 1 bis 8, **dadurch gekennzeichnet, dass** die Materialschicht mit hohem Brechungsindex, der sich von jenem des MgF₂ unterscheidet, eine streifenfreie Schicht ist.

10. Verfahren nach einem der Ansprüche 1 bis 9, umfassend vor dem Aufbringen der Materialschicht mit einem zum MgF₂ unterschiedlichen Brechungsindex (4, 4') den vorherigen Schritt des Aufbringens einer Schicht mit niedrigem Brechungsindex (3).

11. Verfahren nach Anspruch 10, bei dem die Schicht mit niedrigem Brechungsindex (3) eine Dicke von 40 bis 200 nm, vorzugsweise von 60 nm, hat.

12. Verfahren nach einem der Ansprüche 1 bis 11, bei dem der Schritt des Aufbringens der Materialschicht mit zum MgF₂ unterschiedlichem Brechungsindex die folgenden Schritte umfasst:
- Aufbringen einer ersten Materialschicht mit zum MgF₂ unterschiedlichem Brechungsindex (4);
- Aufbringen einer Materialschicht mit niedrigem Brechungsindex (3'); und
- Aufbringen einer zweiten Materialschicht mit zum MgF₂ unterschiedlichem Brechungsindex (4').

13. Verfahren nach Anspruch 12, bei dem die Schicht mit niedrigem Brechungsindex aus SiO₂ ist.

14. Verfahren nach Anspruch 12 oder 13, bei dem die erste Materialschicht mit zum MgF₂ unterschiedlichem Brechungsindex (4) eine Dicke von 10 bis 40 nm aufweist.

15. Verfahren nach einem der Ansprüche 12 bis 14, bei dem die Schicht mit niedrigem Brechungsindex (3') eine Dicke von 10 bis 100 nm, vorzugsweise von 40 nm, hat.

16. Verfahren nach einem der Ansprüche 12 bis 15, bei dem die zweite Materialschicht mit zum MgF₂ unterschiedlichem Brechungsindex (4') eine Dicke von 50 bis 150 nm, vorzugsweise von 120 bis 130 nm, aufweist.

17. Verfahren nach einem der Ansprüche 1 bis 16, bei dem das organische Substrat (1) aus Polykarbonat besteht.

18. Verfahren nach einem der Ansprüche 1 bis 17, bei dem die äußere Schicht aus MgF₂ (5) eine Dicke von 50 bis 100 nm, vorzugsweise von 80 bis 90 nm, aufweist.

19. Verfahren nach einem der Ansprüche 1 bis 18, umfassend den anschließenden Schritt der Aufbringung einer Schicht (6), die die Oberflächenenergie verändert.

20. Organisches Substrat, das mit einer Antireflexionsbeschichtung überzogen ist, insbesondere Augenlinse, und das durch das Verfahren nach einem der Ansprüche 1 bis 19 hergestellt werden kann.
